# EUROPÄISCHE PATENTSCHRIFT

(11) **EP 2 223 415 B1**
(45) Veröffentlichungstag und Bekanntmachung des Hinweises auf die Patenterteilung: **12.10.2011**
(21) Anmeldenummer: 07857157.7
(22) Anmeldetag: 28.12.2007
(51) Int. Cl.: H02K 11/02, H03H 7/09, H03K 17/16, H05K 1/02

(54) **SCHALTUNGSANORDNUNG ZUR EMV-ENTSTÖRUNG**
CIRCUIT CONFIGURATION FOR ELIMINATING EMC INTERFERENCE
DISPOSITIF DE COMMUTATION POUR L'ANTIPARASITAGE CEM

(43) Veröffentlichungstag der Anmeldung: 01.09.2010
(73) Patentinhaber: Siemens Aktiengesellschaft, 80333 München (DE)
(72) Erfinder: OPPERMANN, Christian, 92224 Amberg (DE); STREICH, Bernhard, 92224 Amberg (DE)
(86) Internationale Anmeldenummer: PCT/EP2007/011466
(87) Internationale Veröffentlichungsnummer: WO 2009/083021

(56) Entgegenhaltungen:
- EP-A- 1 071 212
- DE-A1- 2 421 959
- GB-A- 856 224
- JP-A- 2 250 410

## Beschreibung

Die Erfindung betrifft eine Schaltungsanordnung zur EMV-Entstörung eines elektrischen Verbrauchers, wobei an wenigstens eine Versorgungsleitung des elektrischen Verbrauchers ein Dämpfungsglied der Schaltungsanordnung anschließbar ist. Des Weiteren betrifft die Erfindung ein Gerät, welches eine derartige Schaltungsanordnung zur EMV-Entstörung aufweist.

Eine derartige Schaltungsanordnung wird für elektrische Verbraucher wie beispielsweise eine Spulenansteuerung oder eines Schaltnetzteils im Zusammenhang mit getakteten Elektroniken, die Störsignale aussenden können, verwendet. Insbesondere in Stromnetzen, aber auch in anderen Anwendungsfeldern sind zur Eliminierung derartiger Störsignale Schaltungsanordnungen zur elektromagnetischen Verträglichkeit (EMV) notwendig. Die Schaltungsanordnungen basieren in der Regel auf einem Kondensator mit einer großen Kapazität, welcher an Versorgungsleitungen, insbesondere am Eingang der jeweils zu schützenden Schaltung vorgesehen ist. Hierbei dient der Kondensator als Puffer oder Dämpfer für mögliche Stromspitzen, die von der getakteten Elektronik stammen. Eine EMV-Schaltungsanordnung kann als solche separat in einem Modul oder integriert in einem Gerät eingesetzt werden.

Problematisch ist die große Kapazität des Kondensators, welcher als Dämpfungsglied verwendet wird, immer dann, wenn das verwendete Versorgungsnetz nur eine begrenzte Stromaufnahme zulässt. Da der Kondensator an eine Versorgungsleitung geschaltet ist, entsteht beim Einschalten des Gerätes bzw. des Verbrauchers, in den eine Schaltungsanordnung integriert oder diesem vorgeschaltet ist, kurz nach dem Einschalten ein hoher Ladestrom, um den Kondensator aufzuladen. Folglich muss grundsätzlich abgewogen werden, ob wegen der EMV ein Kondensator mit großer Kapazität zu verwenden ist, oder ob die strommäßige Belastbarkeit des Netzes die Kapazität des Kondensators begrenzen soll.

Bisher wurden in diesem Zusammenhang Drosseln oder Strombegrenzer eingesetzt, z.B. ein widerstand in Reine zum Kondensator, wire in JP 02250410, die in der Versorgungsleitung dafür sorgten, dass der Ladestrom auf ein erträgliches Minimum begrenzt wird. Der Nachteil dieser Lösung liegt darin, dass das begrenzende Element im Energiekreis lokalisiert ist und damit während des Betriebes eines Verbrauchers permanent Verluste erzeugt.

Aus der WO 2005/006519 A1 ist eine Schaltungsanordnung zur EMV-Entstörung eines Gleichstrommotors bekannt. Es wird eine Schaltungsanordnung gelehrt, die zur EMV-Entstörung des DC-Motors in den Leitungen desselben ein Dämpfungsglied vorsieht.

Der Erfindung liegt die Aufgabe zugrunde, eine Schaltungsanordnung bzw. ein Gerät anzugeben, welches eine hohe Elektromagnetische Verträglichkeit bei niedriger Verlustleistung ermögliche. Im Zusammenhang mit dem Ladekreis für einen Schriffunstor schlägt DE 2421959 vor, den Ladewiderstand in zwei widerstände aufzuteilen und den einen wisderstand mit einem Transistor zu überbrücken. Diese Aufgabe wird bei einer Schaltungsanordnung der eingangs genannten Art nach Anspruch 1 dadurch gelöst, dass das Dämpfungsglied zusammen mit einem strombegrenzenden Element der Schaltungsanordnung in Reihe, parallel zum Verbraucher anschließbar ist, und dass das strombegrenzende Element mittels eines Schaltes überbrüdebar ist. Die erfindungsgemäße Schaltungsanordnung zur EMV-Entstörung eines elektrischen Verbrauchers weist ein Dämpfungsglied auf, welches in der gleichen Art und Weise wie die bereits vorbekannten Dämpfungsglieder funktioniert. Der Erfindungsgegenstand ist gekennzeichnet durch ein strombegrenzendes Element, welches mit dem Dämpfungsglied in Reihe geschaltet ist. Das Dämpfungsglied und das strombegrenzende Element sind beide zum Verbraucher oder zu mehreren nachgeschalteten Verbrauchern parallel geschaltet. Wichtig ist, dass während des Aufladevorgangs des Dämpfungsgliedes, bzw. des oder der darin enthaltenen Kondensatoren, der Aufladestrom durch das strombegrenzende Element begrenzt wird. Nach dem Aufladevorgang, insbesondere während des Betriebes des oder der Verbraucher, soll eine Verlustleistung am strombegrenzenden Element vermieden werden. Durch dessen parallele Anordnung zu den Verbrauchern liegt das strombegrenzende Element nicht im Energiekreis und erzeugt auch keine Verlustleistung. Für eine optimale EMV-Entstörungsfunktion während des Betriebes ist vorgesehen, dass das strombegrenzende Element mittels eines Schalters, insbesondere eines Transistors, überbrückbar ist. Folglich können zwei Zustände der Schaltungsanordnung unterschieden werden. Zum Einen gibt es den Ladezustand, der solange vorhält, bis das Dämpfungsglied den gewünschten Aufladezustand erreicht hat und zum Anderen einen Betriebszustand, bei dem das strombegrenzende Element durch den Schalter überbrückt ist, womit während des Betriebes des oder der Verbraucher das strombegrenzende Element keine Verlustleistung verursacht.

Bei einer vorteilhaften Ausführungsform ist der Schalter der Schaltungsanordnung von einer ersten Steuerung auslösbar. Die erste Steuerung ist dafür vorgesehen, nach Abschluss des Ladevorganges in den Betriebszustand überzuschalten, womit die EMV-Entstörung aktiv wird. Während des Aufladevorganges ist eine EMV-Entstörung aufgrund des strombegrenzenden Elementes nicht voll umfänglich etabliert, allerdings ist sie auch während des Aufladevorganges entbehrlich.

Bei einer vorteilhaften Ausführungsform ist die erste Steuerung zur Überbrückung des strombegrenzenden Elementes nach dem Aufladevorgang des Dämpfungsgliedes vorgesehen. Die erste Steuerung, die beispielsweise auf der Basis eines Mikroprozessors funktioniert, trifft die Entscheidung, vom Aufladezustand in den Betriebszustand überzugehen. Hierfür wird das Auslösesignal zur Überbrückung des strombegrenzenden Elementes abgegeben.

Vorteilhafterweise weist die erste Steuerung ein Mittel zur Zeitmessung, insbesondere einen Zähler, auf. Der Aufladevorgang bzw. die Dauer desselben, ist im Vorhinein bestimmbar, so dass die erste Steuerung lediglich auf der Basis eines Zeitintervalls die Überbrückung des strombegrenzenden Elementes hervorruft. Hierbei kann die erste Steuerung mit einem festen Zeitintervall vorprogrammiert sein oder es besteht die Möglichkeit der nachträglichen elektronischen Programmierung oder Einstellung dieses Intervalls. Eine manuelle Einstellung erfolgt beispielsweise über eine Potentiometerschaltung, die in die erste Steuerung zur manuellen Kontrolle mittels einer Handhabe integriert werden kann.

Bei einer vorteilhaften Ausführungsform weist die erste Steuerung Mittel zur Detektion eines Aufladezustandes des Dämpfungsgliedes auf. Bei dieser Ausführungsform detektiert die erste Steuerung den Aufladezustand des Dämpfungsgliedes, um zu evaluieren, ob der gewünschte Aufladezustand, der ggf. einstellbar ist, erreicht ist. Dies kann beispielsweise durch eine Spannungsmessung am oder im Dämpfungsglied geschehen. Der gemessene Spannungswert wird an die erste Steuerung zur Erkennung des Aufladezustandes weitergeleitet. Dadurch ergibt sich eine Unabhängigkeit der Schaltungsanordnung vom Stromnetz insoweit, dass unterschiedliche Aufladezeiten ohne weiteres berücksichtigt werden können, ohne eine Einstellung an der Schaltungsanordnung vorzunehmen.

Bei einer vorteilhaften Ausführungsform ist das Dämpfungsglied und/ oder die Schaltungsanordnung zum Austausch des Dämpfungsgliedes vorgesehen. Je nachdem, welche EMV-Entstörung realisiert werden soll bzw. welcher EMV-Grad erreicht werden soll, kann ein entsprechendes Dämpfungsglied, welches beispielsweise eine angepasste Kapazität aufweist, manuell vom Benutzer in die Schaltungsanordnung eingesetzt werden. Durch die Austauschmöglichkeit des Dämpfungsgliedes ist die Schaltungsanordnung flexibel für verschiedene Grade der EMV-Entstörung einsetzbar.

Bei einer vorteilhaften Ausführungsform ist das Dämpfungsglied zur Dämpfungsregulierung vorgesehen. Hierbei werden dämpfungsrelevante Größen, insbesondere die Kapazität, entweder durch den Benutzer manuell regulierbar oder es wird hierfür eine zweite Steuerung vorgesehen. Die zweite Steuerung kann von außerhalb der Schaltungsanordnung bzw. des Gerätes die Dämpfungsregulierung umsetzen. Entsprechendes kann durch eine zweite Steuerung erreicht werden, die innerhalb der Schaltungsanordnung lokalisiert ist. Hierdurch wird eine sehr hohe Flexibilität erreicht, wobei auf die Gegebenheiten des Versorgungsnetzes optimal Rücksicht genommen werden kann. Zudem ist es möglich, dass ein ganz bestimmter Aufladezustand für den normalen Betrieb vorgesehen wird, der sich als optimal zur EMV-Entstörung für das jeweilige Netz erwiesen hat.

Bei einer vorteilhaften Ausführungsform ist das strombegrenzende Element zur Regulierung eines strombegrenzenden Gesamtwiderstandes vorgesehen. Dies ist insbesondere dann sinnvoll, wenn das strombegrenzende Element mit einem oder mehreren ohmschen Widerständen gebildet ist. Die Regulierung des strombegrenzenden Gesamtwiderstandes kann wieder manuell durch den Benutzer oder automatisch durch die erste oder zweite Steuerung bewerkstelligt werden. Hierdurch ist die Länge des Aufladevorganges regulierbar, wobei auch auf die Leistungsfähigkeit des Netzes abgestellt werden kann.

Vorteilhafterweise ist die zweite Steuerung zur Steuerung des strombegrenzenden Gesamtwiderstandes des strombegrenzenden Elementes und/oder zur Steuerung der Dämpfungsregulierung des Dämpfungsgliedes vorgesehen. Hierbei kann die zweite Steuerung eine manuelle Steuerung, eine automatische Steuerung und/oder mit der ersten Steuerung identisch sein.

Weitere vorteilhafte Ausbildungen und bevorzugte Weiterbildungen der Erfindung sind der Figurenbeschreibung und/oder den Unteransprüchen zu entnehmen.

Im Folgenden wird die Erfindung anhand der zur Figur dargestellten Ausführungsbeispiele näher beschrieben und erläutert.

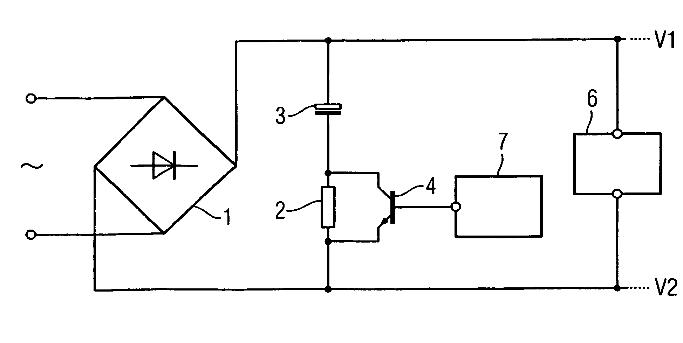

FIG 1 zeigt eine Schaltungsanordnung zur EMV-Entstörung eines elektrischen Verbrauchers 6 mit einem Gleichrichter 1. Der Gleichrichter 1 ist an ein Wechselstromnetz angeschlossen, wobei an diesem über die Versorgungsleitungen V1 und V2 die Schaltungsanordnung zur EMV-Entstörung angeschlossen ist. Parallel zur Schaltungsanordnung zur EMV-Entstörung ist der Verbraucher 6 angeschlossen.

Der Gleichrichter 1 ist an ein Wechselstromnetz anschließbar und versorgt den Verbraucher 6 über die Versorgungsleitungen V1 und V2 mit Gleichstrom. Die Schaltungsanordnung zur EMV-Entstörung besteht in diesem Ausführungsbeispiel aus dem Dämpfungsglied 3, welches als Kondensator 3 ausgeführt ist, dem strombegrenzenden Element 2, dem Schalter 4 und der Steuerung 7. Somit ist die Schaltungsanordnung zwischen die beiden Versorgungsleitungen V1 und V2 bzw. parallel zum Verbraucher 6, der beispielsweise einen Gleichstrommotor, eine Spulenansteuerung oder ein Schaltnetzteil ist oder beinhaltet, geschaltet.

In diesem Ausführungsbeispiel sind lediglich die beiden Versorgungsleitungen V1 und V2 dargestellt, jedoch ist eine erfindungsgemäße Schaltungsanordnung zur EMV-Entstörung grundsätzlich auch in mehrphasigen Netzen anwendbar, wobei die Entstörung bzw. der Anschluss der Schaltungsanordnung eine synchrone oder asynchrone EMV-Entstörung unterstützt.

Der Kondensator 3 dient zur Dämpfung bzw. zur Eliminierung von Stromspitzen, die aus einer getakteten Elektronik aus dem Netz oder von einem anderen Verbraucher her stammen, die an die Versorgungsleitungen V1,V2 angeschlossen sind. Die EMV-Entstörung ist aktiv, wenn das strombegrenzende Element 2, welches als ohmscher Widerstand ausgeführt ist, durch den Schalter 4 niederohmig überbrückt worden ist. Dies entspricht dem Betriebszustand, für welches die EMV-Entstörung optimal funktionieren soll.

Im Aufladezustand erfolgt die Aufladung des Kondensators 3 durch das stromversorgende Netz über den Gleichrichter 1. Das strombegrenzende Element 2 sorgt dabei für einen für das Netz verträglichen Stromfluss auf den Kondensator 3. Sobald der gewünschte Aufladezustand des Kondensators 3 erreicht ist, findet eine Überbrückung des strombegrenzenden Elementes 2 durch den Schalter 4 statt.

Es ist vorteilhaft, den Kondensator 3 während eines Aufladevorganges strombegrenzt aufzuladen, zumal währenddessen die EMV-Wirksamkeit noch nicht benötigt wird. Zudem kommt es zu keiner dauerhaften Verlustleistung durch das strombegrenzende Element 2, da dieses nicht im Energiekreis, d.h., in einer der Versorgungsleitungen V1,V2 geschaltet ist. Mit anderen Worten, eine optimale Netzanpassung und eine optimale EMV-Entstörung werden jeweils zu unterschiedlichen Zeiten separat realisiert, wobei die eine Funktion zugunsten der anderen in Abhängigkeit des Bedarfs vorangestellt wird.

Die Steuerung 7 stellt in diesem Ausführungsbeispiel eine erste Steuerung 7 zur Auslösung des Schalters 4 dar, der die Überbrückung des strombegrenzenden Elementes 2 hervorruft. Im einfachsten Fall richtet sich die Steuerung 7 nach einem internen Zähler, der nach einem vorbestimmten Zeitintervall, welches vom Benutzer ggf. vorgegeben werden kann, eine Auslösung des Schalters 4 provoziert. Der Zähler beginnt zu laufen, wenn die Schaltungsanordnung an das Netz bzw. an den Gleichrichter 1 angeschlossen worden ist und somit der Aufladevorgang des Kondensators 3 begonnen hat.

Eine nicht gezeigte zweite Steuerung könnte zusätzlich eine Dämpfungsregulierung dadurch realisieren, dass anstatt des Kondensators 3 eine Kondensatorschaltung angeordnet wird, die eine Regulierung der Dämpfung, beispielsweise über eine Regulierung der Kapazität, bewerkstelligt. Vorteilhafterweise ist die zweite Steuerung in die erste Steuerung integriert, womit die Steuerung 7 beide Funktionen übernehmen könnte.

Die Schaltungsanordnung ist vorteilhafterweise in Form eines Moduls realisierbar, welches die einzelnen Verbraucher und damit auch innerhalb eines Netzes lediglich durch den Anschluss des Moduls an die Versorgungsleitungen schützt.

Gleichermaßen ist es vorteilhaft einzelne Verbraucher - also beispielsweise Geräte wie Netzgeräte, Schaltnetzteile, Spulenansteuerungen oder ähnliche Geräte mit derartigen integrierten Schaltungsanordnungen auszurüsten. Damit ist der Schutz auf das jeweilige Gerät zugeschnitten.

Zusammenfassend betrifft die Erfindung eine Schaltungsanordnung zur EMV-Entstörung bzw. ein Gerät, welches eine derartige Schaltungsanordnung aufweist, wobei an wenigstens eine Versorgungsleitung, die zu dem oder den Verbrauchern führt, ein Dämpfungsglied angeschlossen ist. Ziel ist es, eine optimale EMV-Entstörung des oder der elektrischen Verbraucher sicherzustellen und ebenso eine Überbeanspruchung des stromversorgenden Netzes zu vermeiden. Hierfür ist das Dämpfungsglied zusammen mit einem strombegrenzenden Element in Reihe zu schalten und zum Verbraucher parallel anschließbar. Somit ist es möglich, über einen Schalter das strombegrenzende Element für den Betriebszustand kurzzuschließen bzw. dessen Wirkung zu kompensieren, womit dieses außerhalb des Energiekreises keine Verlustleistung verursacht und dennoch während des Einschaltvorganges bzw. Aufladevorganges strombegrenzend, d.h. netzfreundlich, wirksam ist.

## Patentansprüche

1. Schaltungsanordnung zur EMV-Entstörung eines elektrischen Verbrauchers (6), wobei an wenigstens eine Versorgungsleitung (V1,V2) des elektrischen Verbrauchers (6) ein Dämpfungsglied (3) der Schaltungsanordnung anschließbar ist, wobei das Dämpfungsglied (3) zusammen mit einem strombegrenzenden Element (2) der Schaltungsanordnung in Reihe, parallel zum Verbraucher (6) anschließbar ist, **dadurch gekennzeichnet, dass** das strombegrenzende Element (2) mittels eines Schalters (4) überbrückbar ist.

2. Schaltungsanordnung nach Anspruch 1, wobei der Schalter (4) von einer ersten Steuerung (7) auslösbar ist.

3. Schaltungsanordnung nach Anspruch 2, wobei die erste Steuerung (7) zur Überbrückung des strombegrenzenden Elements (2) nach einem Aufladevorgang des Dämpfungsgliedes (3) vorgesehen ist.

4. Schaltungsanordnung nach Anspruch 3, wobei die erste Steuerung (7) ein Mittel zur Zeitmessung, insbesondere einen Zähler, aufweist.

5. Schaltungsanordnung nach Anspruch 3, wobei die erste Steuerung (7) Mittel zur Detektion eines Aufladezustandes des Dämpfungsgliedes (3) aufweist.

6. Schaltungsanordnung nach einem der vorhergehenden Ansprüche, wobei das Dämpfungsglied (3) einen Kondensator oder eine Kondensatorschaltung aufweist.

7. Schaltungsanordnung nach einem der vorhergehenden Ansprüche, wobei das Dämpfungsglied (3) austauschbar und/oder zur Dämpfungsregulierung vorgesehen ist.

8. Schaltungsanordnung nach einem der vorhergehenden Ansprüche, wobei das strombegrenzende Element (2) einen oder mehrere ohmsche Widerstände aufweist.

9. Schaltungsanordnung nach einem der vorhergehenden Ansprüche, wobei das strombegrenzende Element (2) zur Regulierung eines strombegrenzenden Gesamtwiderstandes vorgesehen ist.

10. Schaltungsanordnung nach einem der vorhergehenden Ansprüche, wobei eine zweite Steuerung zur Steuerung des Widerstandes strombegrenzenden Elementes (2) und/oder zur Steuerung der Dämpfungsregulierung des Dämpfungsgliedes (3) vorgesehen ist.

11. Schaltungsanordnung nach Anspruch 10, wobei die zweite Steuerung eine manuelle Steuerung oder eine automatische Steuerung, insbesondere die erste Steuerung (7), ist.

12. Elektrisches Gerät mit einer Schaltungsanordnung zur EMV-Entstörung nach einem der vorhergehenden Ansprüche, wobei die Schaltungsanordnung zur EMV-Entstörung des elektrischen Gerätes vorgesehen ist und an wenigstens eine Versorgungsleitung des elektrisches Gerätes ein Dämpfungsglied (3) der Schaltungsanordnung angeschlossen ist, wobei das Dämpfungsglied (3) zusammen mit einem strombegrenzenden Element (2) der Schaltungsanordnung in Reihe, parallel zu einem geräteinternen Verbraucher angeschlossen ist.

13. Gerät nach Anspruch 12, wobei das Gerät als Netzgerät, Schaltnetzteil, Spulenansteuerung oder EMV-Modul ausgebildet ist.

## Claims

1. Circuit arrangement for eliminating EMC interference of an electrical consumer (6), with it being possible to connect a damping member (3) of the circuit arrangement to at least one supply line (V1, V2) of the electrical consumer (6), with it being possible for the damping member (3) to be connected in series together with a current-limiting element (2) of the circuit arrangement, in parallel to the consumer (6), **characterized in that** the current-limiting element (2) is bridgeable by means of a switch (4).

2. Circuit arrangement according to claim 1, with the switch (4) being triggerable by a first controller (7).

3. Circuit arrangement according to claim 2, with the first controller (7) for bridging the current-limiting element (2) being provided after a charging process of the damping member (3).

4. Circuit arrangement according to claim 3, with the first controller (7) having means for time measurement, in particular a counter.

5. Circuit arrangement according to claim 3, with the first controller (7) having means for detecting a charging state of the damping member (3).

6. Circuit arrangement according to one of the preceding claims, with the damping member (3) having a capacitor or a capacitor circuit.

7. Circuit arrangement according to one of the preceding claims, with the damping member (3) being exchangeable and/or provided for damping regulation purposes.

8. Circuit arrangement according to one of the preceding claims, with the current-limiting element (2) having one or more ohmic resistors.

9. Circuit arrangement according to one of the preceding claims, with the current-limiting element (2) being provided for regulating a current-limiting overall resistance.

10. Circuit arrangement according to one of the preceding claims, with a second controller for controlling the resistance of the current-limiting element (2) and/or for controlling the damping regulation of the damping member (3) being provided.

11. Circuit arrangement according to claim 10, with the second controller being a manual controller or an automatic controller, in particular the first controller (7).

12. Electrical device with a circuit arrangement for eliminating EMC interference according to one of the preceding claims, with the circuit arrangement for eliminating EMC interference of the electrical device being provided and a damping member (3) of the circuit arrangement being connected to at least one supply line of the electrical device, with the damping element (3) being connected in series together with a current-limiting element (2) of the circuit arrangement, in parallel to a device-internal consumer.

13. Device according to claim 12, with the device being embodied as a power supply unit, switching power supply, coil control or EMC module.

## Revendications

1. Montage d'antiparasitage CEM d'un utilisateur ( 6 ) électrique, dans lequel un élément ( 3 ) d'amortissement du montage peut être raccordé à au moins une ligne ( V1, V2 ) d'alimentation de l'utilisateur ( 6 ) électrique, l'élément ( 3 ) d'amortissement pouvant être, ensemble avec un élément ( 2 ) limiteur de courant du montage en série, raccordé en parallèle à l'utilisateur, **caractérisé en ce que** l'élément ( 2 ) limiteur de courant peut être court-circuité au moyen d'un interrupteur ( 4 ).

2. Montage suivant la revendication 1, dans lequel l'interrupteur ( 4 ) peut être déclenché par une première commande ( 7 ).

3. Montage suivant la revendication 2, dans lequel la première commande ( 7 ) pour court-circuiter l'élément ( 2 ) limiteur de courant est prévue après une opération de charge de l'élément ( 3 ) d'amortissement.

4. Montage suivant la revendication 3, dans lequel la première commande ( 7 ) a un moyen de mesure du temps, notamment un compteur.

5. Montage suivant la revendication 3, dans lequel la première commande ( 7 ) a des moyens de détection d'un état de charge de l'élément ( 3 ) d'amortissement.

6. Montage suivant l'une des revendications précédentes, dans lequel l'élément ( 3 ) d'amortissement comporte un condensateur ou un circuit de condensateur.

7. Montage suivant l'une des revendications précédentes, dans lequel l'élément ( 3 ) d'amortissement est prévu remplaçable et/ou pour la régulation de l'amortissement.

8. Montage suivant l'une des revendications précédentes, dans lequel l'élément ( 2 ) limiteur de courant a une ou plusieurs résistances ohmiques.

9. Montage suivant l'une des revendications précédentes, dans lequel l'élément ( 2 ) limiteur de courant est prévu pour la régulation d'une résistance globale de limitation du courant.

10. Montage suivant l'une des revendications précédentes, dans lequel une deuxième commande est prévue pour la commande de la résistance de l'élément ( 2 ) de limitation du courant et/ou pour la commande de la régulation de l'amortissement de l'élément ( 3 ) d'amortissement.

11. Montage suivant la revendication 10, dans lequel la deuxième commande est une commande manuelle ou une commande automatique, en étant notamment la première commande ( 7 ).

12. Appareil électrique ayant un montage pour l'antiparasitage CEM suivant l'une des revendications précédentes, le montage étant prévu pour l'antiparasitage CEM de l'appareil électrique et un élément ( 3 ) d'amortissement du montage étant raccordé à au moins une ligne d'alimentation de l'appareil électrique, l'élément ( 3 ) d'amortissement étant, ensemble avec un élément ( 2 ) limiteur de courant du montage en série, monté en parallèle avec un utilisateur interne à l'appareil.

13. Appareil suivant la revendication 12, dans lequel l'appareil est constitué sous la forme d'un appareil de réseau, d'une alimentation à découpage, d'une commande de bobine ou d'un module CEM.
